Europäisches Patentamt
European Patent Office
Office européen des brevets

(19)

(11) Veröffentlichungsnummer: **0 156 281**
**A2**

(12)

# EUROPÄISCHE PATENTANMELDUNG


(21) Anmeldenummer: **85103114.6**

(22) Anmeldetag: **18.03.85**

(51) Int. Cl.$^4$: **H 01 S 3/098**
H 01 S 3/096, H 01 S 3/08

(30) Priorität: **19.03.84 DE 3410051**

(43) Veröffentlichungstag der Anmeldung: **02.10.85 Patentblatt 85/40**

(84) Benannte Vertragsstaaten: **AT BE CH DE FR GB IT LI LU NL SE**



(71) Anmelder: **Max-Planck-Gesellschaft zur Förderung der Wissenschaften e.V.**
**Bunsenstrasse 10**
**D-3400 Göttingen(DE)**

(72) Erfinder: **Göbel, Ernst O., Dr. habil.**
**Manosquerstrasse 3**
**D-7022 Leinfelden-Echterdingen 1(DE)**

(72) Erfinder: **Kuhl, Jürgen, Dr.**
**Einsteinstrasse 43**
**D-7250 Leonberg(DE)**

(72) Erfinder: **Veith, Gustav, Dr.**
**Manosquerstrasse 84**
**D-7022 Leinfelden-Echterdingen 1(DE)**

(74) Vertreter: **von Bezold, Dieter, Dr. et al,**
**Postfach 86 02 60**
**D-8000 München 86(DE)**


(54) **Verfahren und Einrichtung zum synchronen Modenkoppeln der longitudinalen Lasermoden eines Halbleiterdiodenlasers.**


(57) Es werden ein Verfahren und eine Einrichtung zum Erzeugen von optischen Strahlungsimpulsen mit einer Dauer in der Größenordnung von Pikosekunden ($10^{-12}$ s) und darunter mittels synchronen Modenkoppelns der longitudinalen Lasermoden eines in einem externen Resonator (36 – 38) betriebenen Halbleiterlaserelements (18) beschrieben. Bei dem erfindungsgemäßen Verfahren wird die zum synchronen Modenkoppeln erforderliche Verstärkungsmodulation des aktiven Halbleiterlaserelements (18) durch Modulation des elektrischen Pumpstromes bewirkt, wobei die Modulation des Pumpstromes über einen schnellen optoelektronischen Schalter (28) erfolgt, der seinerseits durch einen modengekoppelten Master-Laser (10) gesteuert wird. Das vorliegende Verfahren kombiniert die Vorteile des synchronen optischen Pumpens, wie es in kommerziellen modengekoppelten Farnstofflasersystemen verwendet wird, mit der einfachen Art der elektrischen Anregung kommerziell verfügbarer Halbleiterlaserdioden, insbesondere Doppelheterostruktur-Halbleiterlaserdioden. Es stellt eine einfache und preisgünstige Alternative zu synchron gepumpten Farnstofflasersystemen dar und erweitert den Spektralbereich beträchtlich, in dem Strahlungsimpulse mit einer Dauer in der Größenordnung von Pikosekunden erzeugt werden können.


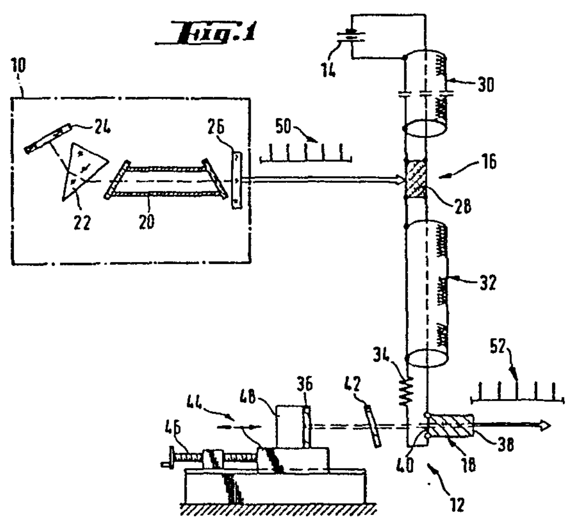

Fig. 1

EP 0 156 281 A2

DR. DIETER v. BEZOLD
DIPL. ING. PETER SCHÜTZ
DIPL. ING. WOLFGANG HEUSLER
PATENTANWÄLTE
MARIA-THERESIA-STRASSE 22
POSTFACH 860260
D-8000 MUENCHEN 86

0156281



ZUGELASSEN BEIM
EUROPÄISCHEN PATENTAMT
EUROPEAN PATENT ATTORNEYS
MANDATAIRES EN BREVETS EUROPÉENS

11527/EP Dr.v.B/Schä/13

TELEFON (089) 4706006
TELEX 522638
TELEGRAMM SOMBEZ
FAX GR II + III (089) 2716063

Max-Planck-Gesellschaft
zur Förderung der Wissenschaften e.V.,
Bunsenstrasse 10, D-3400 Göttingen (DE)

Verfahren und Einrichtung zum synchronen
Modenkoppeln der longitudinalen Lasermoden
eines Halbleiterdiodenlasers

Die vorliegende Erfindung betrifft ein Verfahren und eine Einrichtung zum synchronen Modenkoppeln der longitudinalen Lasermoden eines Halbleiterdiodenlasers.

Optische Lichtimpulse mit einer Dauer in der Größenordnung von Pikosekunden und Bruchteilen von Pikosekunden können durch Koppeln der Phasen der in einem Laserresonator angeregten Schwingungsmoden, also durch das sogenannte "Mode-Locking", erzeugt werden. Die erzielbare minimale Pulsbreite ist um so kleiner, je größer die Verstärkungsbandbreite des laseraktiven Mediums ist. Lasermedien mit großer Verstärkungsbandbreite, wie z.B. Lösungen organischer Farbstoffe, Farbzentrenkristalle und Halbleiter, eigenen sich daher in besonderem Maße zur Erzeugung kürzester optischer Strahlungsimpulse.

Eine gängige Art des Modenkoppelns ist die synchrone optische Anregung ("synchrones Pumpen") eines Lasers durch einen modengekop-

pelten zweiten Laser geringerer Bandbreite, siehe z.B. die Veröffentlichung von W.H. Glenn et al. in (Appl. Phys. Lett. 12, 54, 1968). Das synchrone Modenkoppeln wird dadurch erreicht, daß die optische Länge des die Pumpimpulse erzeugenden Lasers gleich oder gleich einem ganzen Vielfachen der optischen Länge des Laserresonators des gepumpten Lasers ist. Synchron modengekoppelte Farbstofflasersysteme dieser Art sind im Handel erhältlich und erlauben die Erzeugung von Pikosekunden-Lichtimpulsen im sichtbaren und nahen Infrarotbereich bis etwa 0,9 $\mu$m ($10^{-6}$m).

Halbleiterlaser zeichnen sich im Vergleich zu Farbstofflasern u.a. durch ihre Kompaktheit (typische Abmessungen 200 $\mu$m x 200 $\mu$m x 100 $\mu$m) und insbesondere die einfache Methode der Anregung mittels eines elektrischen Stromes sowie ihre sehr geringe Leistungsaufnahme (typisch einige 10 bis 100 mW) aus. Darüber hinaus kann mit Halbleiterlasern nahezu der gesamte Spektralbereich zwischen 0,7 $\mu$m und 30 $\mu$m erfaßt werden. Halbleiterlaser für den Spektralbereich von 0,7 bis 1,6 $\mu$m haben einen außerordentlich hohen technologischen Entwicklungsstand erreicht und können bei Zimmertemperatur kontinuierlich weit über 100 000 Stunden betrieben werden.

Für das Modenkoppeln von Halbleiterlasern sind verschiedene Verfahren bekannt geworden, insbesondere:

a) Passives Modenkoppeln (E.P. Ippen et al., Appl. Phys. Lett. 37, 267, 1980 ; J.P. van der Ziel et al., Appl. Phys. Lett. 39, 525, 1981);

b) Aktiv-Passives Modenkoppeln (J.P. van der Ziel et al, Appl. Phys. Lett. 39, 867, 1981);

c) Aktives Modenkoppeln durch Verstärkungsmodulation (J.P. van der Ziel et al, Journ. Appl. Phys. 52, 4435, 1981 ; J.C. AuYeung et al., Appl. Phys. Lett. 40, 112, 1982);

d) Synchrones Modenkoppeln bei optischer Anregung (R.S. Putman et al., Appl. Phys. Lett. 40, 660, 1982).

Bei den Verfahren a), b) und d) können keine kommerziellen Halbleiterdiodenlaser verwendet werden. Die Verfahren a) und b)

erfordern eine aufwendige Präparation einer Laserendseite (Protonen- oder Ionenbestrahlung zur Erzeugung eines internen sättigbaren Absorbers). Das Verfahren d) erfordert im allgemeinen eine Kühlung der Halbleiter-Laserdiode auf tiefe Temperaturen.

Beim Verfahren c) wird die Modenkopplung durch eine Verstärkungsmodulation bewirkt, die ihrerseits durch eine Modulation des die Halbleiterlaserdiode speisenden Stromes erzeugt wird. Die Modulation des Stromes erfolgt rein elektronisch durch Hochfrequenz- oder Impulsgeneratoren. Wie auch bei den Verfahren a) und b) ist beim Verfahren c) keine gleichzeitige Erzeugung synchronisierter modengekoppelter Strahlungsimpulszüge bei verschiedenen Emissionswellenlängen möglich. Keines der obengenannten Verfahren ist mit kommerziellen synchron gepumpten Farbstofflasersystemen kompatibel.

Es ist weiterhin aus der Veröffentlichung von E. O. Göbel et al. in Appl. Phys. Lett. **42** (1), 1. Januar 1983, S. 25 bis 27 bekannt, die Verstärkung eines Halbleiterlasers mittels eines schnellen optoelektronischen GaAs-Schalters zu modulieren. Der Schalter wird durch Strahlungsimpulse von einem modegekoppelten Farbstofflaser gesteuert. Die Emission des Halbleiterlasers ist jedoch immer mehrmodig.

Der vorliegenden Erfindung liegt die Aufgabe zugrunde, ein einfaches Verfahren und eine einfache Einrichtung zum synchronen Modenkoppeln der longitudinalen Lasermoden eines Halbleiterdiodenlasers anzugeben, mit denen Laserstrahlungsimpulse in einem weiten Wellenlängenbereich und mit kurzer Dauer, insbesondere in der Größenordnung von Pikosekunden und darunter, erzeugt werden können.

Diese Aufgabe wird erfindungsgemäß dadurch gelöst, daß eine Halbleiterlaserdiode, die in einem externen optischen Resonator angeordnet ist, mit Strom von einem optoelektronischen Pulsgenerator gespeist wird, der einen durch Strahlungsimpulse eines Muster-Laser gesteuerten optoelektronischen Schalter enthält.

Bei dem vorliegenden Verfahren wird der Halbleiterdiodenlaser durch elektrische Ansteuerungsimpulse hoher zeitlicher Stabilität ange-

steuert, was eine Grundvoraussetzung für ein optimales Modenkoppeln des durch diese Impulse synchron angeregten Halbleiterdiodenlasers ist.

Der Halbleiterlaser wird in einem externen Resonator betrieben, wobei eine Kristallendfläche der Halbleiterlaserdiode den Auskoppelspiegel darstellen kann. Die Reflexion der zweiten Kristallendfläche, die sich im Strahlengang der Laserstrahlung befindet, wird vorzugsweise vermindert, z.B. durch Aufdampfen dielektrischer Schichten. Diese "Entspiegelung" kann nachträglich an kommerziellen Halbleiterlaserdioden mit geringem Aufwand durchgeführt werden.

Das synchrone Modenkoppeln wird dadurch erreicht, daß die Länge des externen Resonators auf die Länge des den optoelektronischen Schalter steuernden Master- Lasers abgestimmt wird, wie es im Prinzip aus der oben erwähnten Veröffentlichung von Glenn bekannt ist.

Dadurch, daß die synchrone Verstärkungsmodulation der Halbleiterlaserdiode durch elektrische Anregung erfolgt, können (im Gegensatz zur optischen Anregung) kommerziell verfügbare Halbleiterlaserdioden verwendet werden. Außer der Entspiegelung einer Kristallendfläche, die bei allen bisher bekannten Verfahren zum Modenkoppeln nötig ist, braucht keine weitere Bearbeitung der Laserdiode vorgenommen zu werden, im Gegensatz zu den bisherigen Methoden des aktiv-passiven und passiven Modenkoppelns gemäß den oben genannten Veröffentlichungen.

Im Vergleich zu synchron optisch gepumpten modengekoppelten Farbstofflasersystemen sind die vorliegenden Lasersysteme um Größenordnungen billiger. Die Erfindung erlaubt im Prinzip die Nachrüstung vorhandener synchron gepumpter modengekoppelter Farbstofflasersysteme, da die zum synchronen optischen Pumpen verwendeten Gaslaser ohne Modifikation zur Ansteuerung des optoelektronischen Schalters eines erfindungsgemäßen Lasersystems verwendet werden können. Durch eine solche Nachrüstung kann der verfügbare Spektralbereich von

Pikosekundenlasersystemen, die einen ununterbrochenen Strahlungsimpulszug liefern, erheblich erweitert werden.

Als optoelektronischer Schalter können außer dem aus der Veröffentlichung von Göbel et al. bekannten Schalterelement auch andere schnelle optoelektronische Schalter verwendet werden, wie konventionelle Photodetektoren mit entsprechend raschem Ansprechverhalten und genügend hohem dynamischem Bereich, wie z. B. Avalanche-Photodioden, PIN-Photodioden.

Der optoelektronische Halbleiterschalter kann vorteilhafterweise mit dem zugehörigen Halbleiterlaser integriert gefertigt werden, z.B. auf einem gemeinsamen isolierenden Substrat, so daß das vorliegende Verfahren mit einem durch die derzeit verfügbare Halbleitertechnologie herstellbaren, sehr kompakten Bauelement realisiert werden kann.

Im folgenden wird die Erfindung unter Bezugnahme auf die Zeichnung näher erläutert, dabei werden noch weitere Merkmale und Vorteile der Erfindung zur Sprache kommen.

Es zeigen:

Fig. 1 eine schematische Darstellung eines modengekoppelten Halbleiterlasers zur Durchführung des vorliegenden Verfahrens und

Fig. 2 eine schematische Darstellung eines Teiles eines Mehrfachlasersystems, das nach dem vorliegenden Verfahren arbeitet.

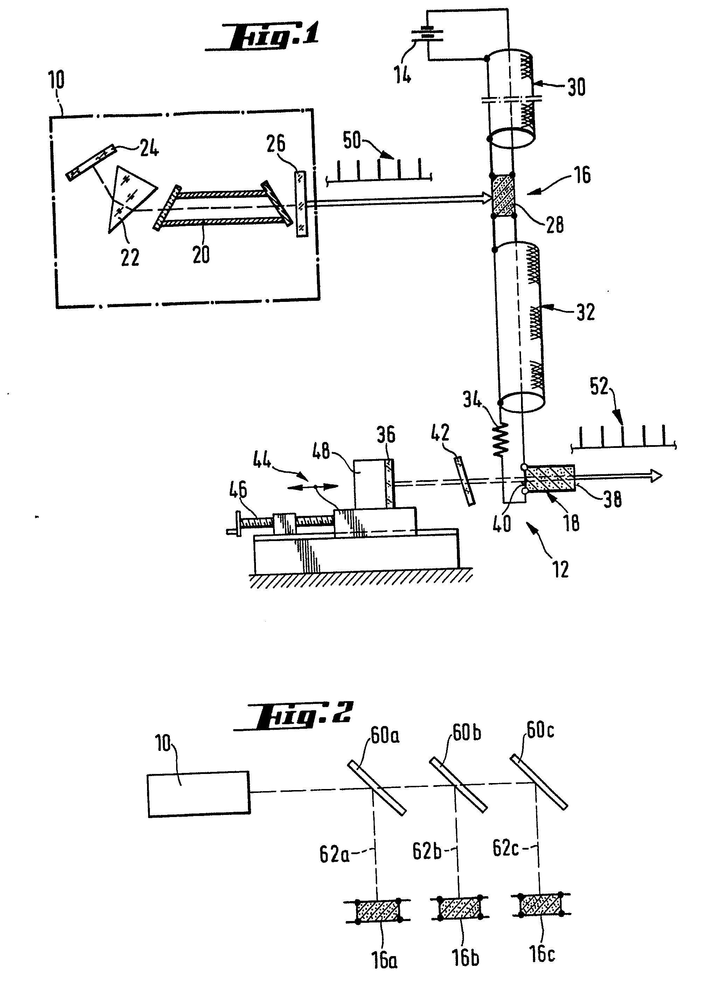

Die in Figur 1 dargestellte Einrichtung enthält im wesentlichen einen modegekoppelten Master-Laser 10, einen Halbleiterlaser 12, eine Anregungs- oder Pumpspannungsquelle 14 für den Halbleiterlaser und einen schnellen optoelektronischen Schalter 16, der zwischen die Pumpspannungsquelle 14 und eine Halbleiter-Laserdiode 18 des Halbleiterlasers 12 geschaltet ist.

Der Master-Laser 10 ist vorzugsweise, wie dargestellt, ein modengekoppelter Gas-Ionen-Laser, wie z.B. $Ar^+$- oder $Kr^+$- Laser, der eine Lasergasküvette 20 und ein Mode-Lock-Prisma 22 enthalten kann, die in einem optischen Resonator angeordnet sind, der durch einen 100 % reflektierenden Spiegel 24 und durch einen teildurchlässigen Spiegel 26 begrenzt ist. Der Laser 10 kann in konventioneller Weise ausgebildet sein, daher ist auch die Pumpenergieversorgung der Einfachheit halber nicht dargestellt.

Anstelle eines Gaslasers kann auch ein anderer Lasertyp als Master-Laser 10 verwendet werden, z.B. ein modengekoppelter Festkörperlaser, wie etwa ein Nd:YAG- oder Rubinlaser oder ein modengekoppelter Farbstofflaser.

Die Halbleiterlaserdiode 18 kann eine handelsübliche BH-GaAs/GaAlAs-Halbleiterdiode sein (BH = Buried Hetero Structure).

Der optoelektronische Schalter 16 enthält ein Photoleiterelement 28, des aus mit Chrom dotiertem Galliumarsenid besteht. Anstelle dieses GaAs:Cr-Photoleiters können auch Avalanche- oder PIN-Photodioden genügend raschen Ansprechverhaltens verwendet werden.

Der optoelektronische Schalter 16 ist, wie dargestellt, zwischen den Innenleiter und den Außenleiter zweier Hochfrequenzleitungen, insbesondere Koaxialkabel 30 bzw. 32 geschaltet, von denen das eine Kabel 30 den Photoleiter 28 mit der Anregungsenergiequelle 14 und das andere Kabel 32 den Photoleiter 28 über einen in Reihe geschalteten Anpassungswiderstand 34 mit der Laserdiode 18 verbindet. Der Anpassungswiderstand 34 paßt den im allgemeinen zu niedrigen Widerstand der Laserdiode 18 an den Wellenwiderstand der Hochfrequenzleitung 32 an, kann aber auch entfallen. Die Halbleiterlaserdiode stellt dann im wesentlichen einen Kurzschluß der Hochfrequenzleitung dar.

Der Halbleiterlaser 12 enthält einen externen optischen Resonator, der einerseits durch einen möglichst vollständig reflektierenden Spiegel 36 und andererseits durch die nur teilweise reflektierende

eine Kristallendfläche 38 des monokristallinen Halbleiterkörpers der Laserdiode 18 begrenzt ist. Die andere Kristallendfläche, die der als Austrittsspiegel dienenden Kristallendfläche 38 entgegengesetzt ist, ist mit einer Antireflexionsschicht 40 versehen. Im optischen Hohlraum oder Resonator des Halbleiterlasers 12 ist vorzugsweise ein optisches Bandfilter 42, z.B. in Form eines Interferenzfilters oder Fabry-Perot-Etalons, angeordnet. Der optische Resonator des Halbleiterlasers kann auch durch zwei externe Spiegel unterschiedlichen Reflexionsvermögens gebildet werden, wobei dann vorzugsweise beide Kristallendflächen des Halbleiterkörpers der Laserdiode entspiegelt werden. Bei Verwendung eines Resonators mit nur einem externen Spiegel kann die als zweiter Resonatorspiegel dienende Kristallendfläche durch eine zusätzliche dielektrische Beschichtung in ihrem Reflexionsvermögen geeignet modifiziert, vorzugsweise erhöht werden, um die Leistung und Dauer der Ausgangsimpulse zu modifizieren.

Die Länge des Resonators des Halbleiterlasers 12 ist zum Abstimmen bezüglich der optischen Länge des Resonators des Masterlasers 10 durch Verschieben des Reflektors 36 verstellbar. Der Reflektor 36 ist hierfür mit einer Verstellvorrichtung 44 verbunden, die eine Grobeinstellvorrichtung 46 und eine Feineinstellvorrichtung 48 enthalten kann. Die Grobeinstellvorrichtung 46 kann beispielsweise, wie dargestellt, einen mittels einer Schraubenspindel verstellbaren Support enthalten, auf dem die Feinverstelleinrichtung 48 befestigt ist. Die Feinverstelleinrichtung 48 kann beispielsweise eine bekannte piezoelektrische Verstelleinrichtung sein, an der der Reflektor 36 angebracht ist.

Die oben beschriebene Einrichtung arbeitet folgendermaßen: Als erstes wird die Länge des Resonators 36-38 des Halbleiterlasers 12 auf die Länge des Resonators 22-24 des Master-Lasers 10 abgestimmt. Die optische Länge des Resonators des Master-Lasers 10 kann auch ein ganzzahliges Vielfaches der Länge des Resonators des Halbleiterlasers sein. Der Master-Laser wird in bekannter Weise (nicht dargestellt) mit Modenkopplung betrieben und liefert einen optischen Impulszug 50 aus kurzen optischen Impulsen, deren Dauer zum Beispiel in der Größenordnung von 100 Pikosekunden und darunter liegen kann.

Diese Impulse steuern den optoelektronischen Schalter 16, der in Ansprache auf jeden Impuls des Impulszuges 50 das der Laserdiode 18 abgewandte Ende der Hochfrequenzleitung 32 kurzschließt. Hierdurch werden dem normalerweise relativ kleinen Dauerstrom des Halbleiterlasers kurze, zeitlich sehr genau definierte Stromimpulse überlagert, die durch die Entladung der Kapazität der Hochfrequenzleitung 32 entstehen. Diese Stromimpulse modulieren den Verstärkungsgrad der Laserdiode, die dadurch im Zusammenwirken mit dem abgestimmten optischen Resonator 36-38 sehr kurze, modengekoppelte optische Ausgangsimpulse 52 liefert, deren Dauer in der Größenordnung von Pikosekunden und darunter liegen.

Die Wellenlänge der Ausgangsstrahlung des Halbleiterlasers 12 kann in bekannter Weise durch das Bandfilter 42 eingestellt werden.

Die vorliegende Erfindung ermöglicht es auch auf einfache Weise, zwei oder mehrere Halbleiterlaser in externen Resonatoren parallel synchron modenzukoppeln. Dazu kann der Impulszug des Master-Lasers 10 durch Strahlteiler 60a, 60b, 60c usw. in zwei oder mehrere Teilstrahlen 62a, 62b und 62c aufgeteilt werden, wie es in Fig. 2 für drei Strahlteiler und Teilstrahlen dargestellt ist. Die Teilstrahlen steuern jeweils einen entsprechenden optoelektronischen Schalter 16a, 16b bzw. 16c, der dann seinerseits einen in Fig. 2 nicht dargestellten Halbleiterlaser entsprechend dem Halbleiterlaser 12 in Fig. 1 steuert. Ein solcher Parallelbetrieb mehrerer Halbleiterlaser wird insbesondere dadurch ermöglicht, daß die Leistung, die zur Ansteuerung der optoelektronischen Schalter und damit der Halbleiterlaser benötigt wird, sehr niedrig ist.

Als Master-Laser kann auch ein gepulster modengekoppelter Laser verwendet werden, der dann entsprechende unterbrochene Pulszüge (Bursts) liefert. Der oder die synchron modengekoppelten Halbleiterlaser liefern dann entsprechend unterbrochene Pulszüge. Letzteres ist besonders wichtig bei Verwendung von passiv modengekoppelten Nd:YAG- oder Rubinlasern sowie bei blitzlampengepumpten Farbstofflasern.

Durch die Erfindung wird also ein Verfahren zum Erzeugen von von optischen Strahlungsimpulsen mit einer Dauer in der Größenordnung von Pikosekunden ($10^{-12}$ s) und darunter mittels synchronen Modenkoppelns der longitudinalen Lasermoden eines in einem externen Resonator betriebenen Halbleiterlaserelements beschrieben. Bei dem erfindungsgemäßen Verfahren wird die zum synchronen Modenkoppeln erforderliche Verstärkungsmodulation des aktiven Halbleiterlaserelements durch Modulation des elektrischen Pumpstromes bewirkt, wobei die Modulation des Pumpstromes über einen schnellen optoelektronischen Schalter erfolgt, der seinerseits durch einen modengekoppelten Laser gesteuert wird. Das vorliegende Verfahren kombiniert die Vorteile des synchronen optischen Pumpens, wie es in kommerziellen modengekoppelten Farbstofflasersystemen verwendet wird, mit der einfachen Art der elektrischen Anregung kommerziell verfügbarer Halbleiterlaserdioden, insbesondere Doppelheterostruktur-Halbleiterlaserdioden. Es stellt eine einfache und preisgünstige Alternative zu synchron gepumpten Farbstofflasersystemen dar und erweitert den Spektralbereich beträchtlich, in dem Strahlungsimpulse mit einer Dauer in der Größenordnung von Pikosekunden erzeugt werden können.

Bei einer praktischen Ausführungsform der Erfindung war der Master-Laser 10 ein handelsüblicher aktiv modengekoppelter $Ar^{+}$-Ionen-Laser der Firma Spectra Physics, Modell 171. Das Photoleiterelement 28 enthielt einen 10 mm x 5 mm x 0,3 mm großen Körper aus handelsüblichem, semi-isolierendem, Cr-dotiertem Galliumarsenid-Substratmaterial mit einem typischen spezifischen Widerstand von $10^{8}$ Ohm·cm, erhältlich von der Firma Wacker Chemitronic, Burghausen/Bundesrepublik Deutschland. Die mit dem Körper des Photoleiters 38 in Verbindung stehenden Teile der Hochfrequenzleitungen werden durch eine Streifenleitung gebildet. Die Streifenleiterbreite war 250 µm, an die die Dicke des Photoleiterkörpers angepaßt ist. Der Zwischenraum zwischen den Enden des Streifenleiters auf der dem Master-Laser 10 zugewandten Seite des Photoleiters 28 war 25 µm breit. Die Steifenleitung hat einen Wellenwiderstand von 50 Ohm.

Die Länge der Hochfrequenzleitung 30 ist nicht kritisch. In der Praxis wurde in etwa 1 m langes Stück kommerzielles Koaxialkabel mit 50 Ohm Wellenwiderstand verwendet. Die Hochfrequenzleitung 32 sollte so kurz wie möglich sein. Sie bestand bei der praktischen Ausführungform aus einem 5 cm langen Stück 50-Ohm-Koaxialkabel. Die Spannung der Spannungsquelle 14 beträgt typischerweise maximal 25 Volt. Die Größe des Anpassungswiderstandes 34 hängt vom Widerstand des optoelektronischen Schalters im beleuchteten Zustand ab und kann zwischen 1 und 50 Ohm liegen. Im vorliegenden Falle wurde ein Anpassungswiderstand 34 von 50 Ohm verwendet.

Als Laserdiode 38 wurde eine Diode des Typs HL-3400 der Firma Hitachi, Japan verwendet. Die Entspiegelung der Endfläche 40 erfolgte durch eine in bekannter Weise (siehe z.B. G. Eisenstein, L.W. Stulz, Applied Optics 23, 161 (1984) hergestellte dielektrische Viertelwellenlängenschicht. Die Wellenlänge der Strahlung des Master-Lasers betrug 514,5 nm. Die Länge des Resonators des Master-Lasers und des externen Resonators der Laserdiode betrugen jeweils etwa 180 cm. Das von der Fläche 40 emittierte Laserlicht wurde mit einem Mikroskopobjektiv (Brennweite f = 0,25 cm) kollimiert. Zur Bandbreitenkontrolle und Abstimmung der Laserdiodenausgangsstrahlung dienten ein schmalbandiges Interferenzfilter (Bandbreite etwa 5 nm), in Kombination mit einem zusätzlichen 80 µm dicken Etalon (R=30 %).

Die Laserdiode lieferte Strahlungsimpulse mit einer Wellenlänge von 841 nm und einer Halbwertsbreite von 30 ps mit einer Wiederholungsfrequenz von 80,32 MHz und einer mittleren Ausgangsleistung von typischerweise 250 Mikrowatt.

PATENTANSPRÜCHE

1. Verfahren zum synchronen Modenkoppeln der longitudinalen Lasermoden eines Halbleiterdiodenlasers **dadurch gekennzeichnet,** daß ein mittels eines Master-Lasers angesteuerter optoelektronischer Pulsgenerator zum synchronen Anregen einer in einem externen Resonator betriebenen Halbleiterlaserdiode verwendet wird.

2. Einrichtung zur Durchführung des Verfahrens nach Anspruch 1 mit einer an eine Pumpstromimpulsquelle angeschlossenen Halbleiter-Laserdiode, welche in einem externen Resonator angeordnet ist, **dadurch gekennzeichnet,** daß die Pumpstromimpulsquelle einen optoelektronischen Schalter (16) kurzer Ansprechdauer, der zwischen eine elektrische Pumpenergiequelle (14) und die Halbleiter-Laserdiode (18) geschaltet ist, und einen Master-Laser (10), der eine Folge kurzer Strahlungsimpulse, die den optoelektronischen Schalter (16) steuern, enthält, und daß der Master-Laser einen optischen Resonator (22-24) enthält, dessen Länge gleich einem ganzzahligen Vielfachen (einschließlich 1) der optischen Länge des externen Resonators (36-38) des Halbleiterlasers ist.

3. Einrichtung nach Anspruch 2, **dadurch gekennzeichnet,** daß der externe Resonator (36-38) des Halbleiterlasers (12) ein frequenzbestimmendes Element (42) enthält.

4. Einrichtung nach Anspruch 2 oder 3, **dadurch gekennzeichnet,** daß der optoelektronische Schalter (16) einen Photowiderstand (28) enthält, welcher über eine Hochfrequenzleitung (32) an die Halbleiter-Laserdiode (18) angeschlossen ist.

5. Einrichtung nach Anspruch 4, **dadurch gekennzeichnet,** daß die Halbleiter-Laserdiode (18) in Reihe mit oder ohne einem Anpassungswiderstand (34) an die Hochfrequenzleitung (32) angeschlossen ist.

6. Einrichtung nach Anspruch 2, 3, 4 oder 5, **dadurch gekennzeichnet**, daß mindestens zwei Halbleiterlaser, die jeweils über einen eigenen optoelektronischen Schalter (16a, 16b, ...) steuerbar sind, vorgesehen sind und daß alle optoelektronischen Schalter durch einen einzigen Master-Laser (10) über eine entsprechende Strahlteileranordnung (60a, 60b, ...) steuerbar sind.

7. Einrichtung nach einem der Ansprüche 2 bis 6, **dadurch gekennzeichnet**, daß der Master-Laser ein gepulster modengekoppelter Laser ist, der unterbrochene Folgen von optischen Strahlungsimpulsen liefert.

0156281

Fig. 1

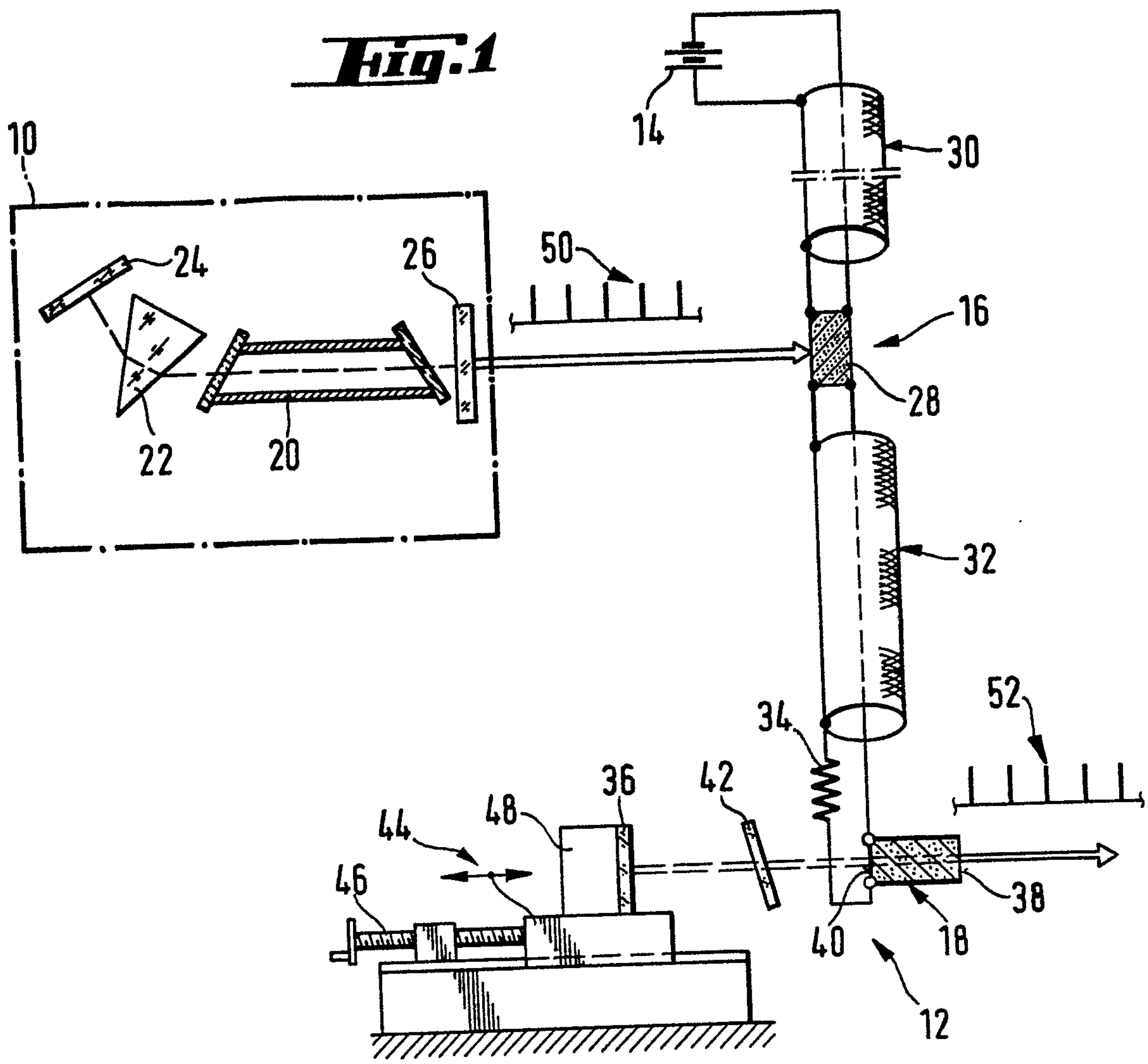


Fig. 2